# EUROPÄISCHE PATENTANMELDUNG

(11) **EP 2 700 953 A2**
(43) Veröffentlichungstag der Anmeldung: **26.02.2014**
(21) Anmeldenummer: 13178191.6
(22) Anmeldetag: 26.07.2013
(51) Int. Cl.: G01R 1/04, G01R 15/18

(54) **Schutzgehäuse für einen Stromwandler sowie Stromwandlermodul**

(30) Priorität: 23.08.2012 CN 201210303108
(71) Anmelder: Siemens Aktiengesellschaft, 80333 München (DE)
(72) Erfinder: Wu, Di, 200122 Shanghai (CN); Wu, Hong Feng, 200037 Shanghai (CN); Bao, Zhang Yao, 93049 Regensburg (DE)

(57) **Zusammenfassung**

Diese Erfindung betrifft ein Schutzgehäuse für einen Stromwandler (4), wobei das besagte Schutzgehäuse mindestens eine erste Abschirmkappe (2a, 2b; 2c, 2d) und zweite Abschirmkappe (3a, 3b; 3c, 3d) umfasst, die besagte erste Abschirmkappe (2a, 2b; 2c, 2d) einen ersten Hohlraum (23) aufweist, der besagte erste Hohlraum (23) für die Aufnahme des besagten Stromwandlers (4) verwendet werden kann, die besagte zweite Abschirmkappe (3a, 3b; 3c, 3d) einen zweiten Hohlraum (33) aufweist, der besagte zweite Hohlraum (33) für die Aufnahme der besagten ersten Abschirmkappe (2a, 2b; 2c, 2d) verwendet werden kann. Da das Schutzgehäuse eine zweischichtige sowie mehr als zweischichtige Abschirmkappe verwendet, können bei jedem Durchgang durch eine Schicht der Abschirmkappe die äußeren magnetischen Störfelder etwas abgeleitet werden, auf diese Weise können der Wandler im Inneren der ersten Abschirmkappe relativ gut geschützt und die Einflüsse äußerer Störungen auf die Ergebnisse der Strommessung effektiv verringert werden.

## Beschreibung

### Technisches Gebiet

Diese Erfindung betrifft das Gebiet der Niederspannungselektrik, betrifft vorrangig ein Schutzgehäuse für einen Stromwandler sowie ein Stromwandlermodul.

### Stand der Technik

Strommesswandler werden in breitem Umfang für das Messen von Leckstrom und in weiteren Gebieten eingesetzt. Da die Störungen von äußeren statischen Magnetfeldern und elektromagnetischen Feldern Messfehler der Stromwandler hervorrufen können, wird eine Abschirmkappe dafür verwendet, die von äußeren Störungen hervorgerufenen Fehler auf einen akzeptablen Bereich zu senken.

Der Aufbau von vorhandenen Schutzgehäusen von Strommesswandlern ist einschichtig, das Material ist Stahl, die Herstellung erfolgt durch Stanzen, und nach der Bearbeitung erfolgt keine thermische Behandlung.

Da der remanente Magnetismus von Stahl selbst relativ groß ist und nach dem Stanzen die intergranularen Spannungen zunehmen, besteht bei jetzigen Schutzgehäusen das Problem eines großen remanenten Magnetismus. Wenn der Stromwandler von einem sehr großen Strom durchflossen wird, kann der remanente Magnetismus des Schutzgehäuses nach dem Verschwinden des Stroms ein statisches Magnetfeld bilden, dieses Magnetfeld koppelt sich mit dem Wandler im Schutzgehäuse, was zum Entstehen von Messfehlern führt. Für Wechselstrommessschaltungen sind die vom remanenten Magnetismus des Schutzgehäuses hervorgerufenen Fehler nicht offensichtlich. Jedoch für Messschaltungen, die auf Verfahren magnetischer Modulation basieren, können aufgrund deren Sensitivität gegenüber Gleichstrom vom remanenten Magnetismus des Schutzgehäuses hervorgerufene statische Magnetfelder direkt zu damit proportionalen Gleichstromfehlern führen.

Der Aufbau von jetzigen Schutzgehäusen von Strommesswandlern ist einschichtig, zwischen aus Stahl hergestellten Abschirmkappen mit hohem remanentem Magnetismus und den Stahlkernen der Wandler besteht keinerlei Abschirmung, was dazu führt, dass die vom remanenten Magnetismus hervorgerufenen Beeinträchtigungen relativ hoch sind. Außerdem ist aufgrund des einschichtigen Aufbaus der Schutz, der geboten werden kann, relativ begrenzt, in einigen Fällen mit relativ extremen magnetischen Störungen sind jetzige einschichtige Schutzgehäuse aus Stahl nicht in der Lage, ausreichenden Schutz zu bieten, was dazu führt, dass die äußeren magnetischen Störungen, denen die Messergebnisse unterliegen, relativ stark sind.

### Gegenstand der Erfindung

Das Ziel dieser Erfindung besteht darin, ein Schutzgehäuse für einen Stromwandler vorzulegen, das die Einflüsse äußerer Störungen auf die Messergebnisse des Stroms effektiv verringern kann.

Ein weiteres Ziel dieser Erfindung besteht darin, ein Stromwandlermodul vorzulegen, das dieses Schutzgehäuse umfasst.

Diese Erfindung legt ein Schutzgehäuse für einen Stromwandler vor, das besagte Schutzgehäuse umfasst mindestens eine erste Abschirmkappe und zweite Abschirmkappe, wobei:
- die besagte erste Abschirmkappe einen ersten Hohlraum aufweist, der besagte erste Hohlraum für die Aufnahme des besagten Stromwandlers verwendet werden kann,
- die besagte zweite Abschirmkappe einen zweiten Hohlraum aufweist, der besagte zweite Hohlraum für die Aufnahme der besagten ersten Abschirmkappe verwendet werden kann.

Da das Schutzgehäuse eine zweischichtige sowie mehr als zweischichtige Abschirmkappe verwendet, können bei jedem Durchgang durch eine Schicht der Abschirmkappe die äußeren magnetischen Störfelder etwas abgeleitet werden, auf diese Weise können der Wandler im Inneren der ersten Abschirmkappe relativ gut geschützt und die Einflüsse äußerer Störungen auf die Ergebnisse von Strommessungen effektiv verringert werden.

Als eine Ausführungsform davon umfasst das besagte Schutzgehäuse noch eine dritte Abschirmkappe, weist die besagte dritte Abschirmkappe einen dritten Hohlraum auf, wird der besagte dritte Hohlraum für die Aufnahme der besagten zweiten Abschirmkappe verwendet. Das heißt auch, dass diese Erfindung nicht auf Schutzgehäuse beschränkt ist, die nur eine zweischichtige Abschirmkappe aufweisen, das Schutzgehäuse kann außerdem eine dreischichtige und sogar eine noch höherschichtige Abschirmkappe aufweisen, und relativ ist unter der Voraussetzung der Erfüllung der grundlegendsten Anforderungen die Schutzwirkung umso besser, je höher die Anzahl der Schichten ist.

Als eine Ausführungsform wird die besagte erste Abschirmkappe durch gegenseitiges Aufsetzen und Verbinden des ersten Obergehäuses und des ersten Untergehäuses gebildet, wird die besagte zweite Abschirmkappe durch gegenseitiges Aufsetzen und Verbinden des zweiten Obergehäuses und des zweiten Untergehäuses gebildet. Ein solcher Aufbau vereinfacht die Platzierung des Wandlers und der ersten Abschirmkappe.

Bevorzugt besteht zwischen der ersten Abschirmkappe und der zweiten Abschirmkappe ein bestimmter Zwischenraum, um einen magnetischen Widerstand zu bilden und den magnetischen Fluss eines äußeren Magnetfelds zu verringern, der die erste Abschirmkappe erreicht.

Als eine Ausführungsform ist zwischen der ersten Abschirmkappe und der zweiten Abschirmkappe Füllmaterial eingefüllt, zum Beispiel Harz oder Gummi usw., um den besagten Zwischenraum zu bilden.

Als eine weitere Ausführungsform ist die erste Abschirmkappe in einer ringförmigen Halterung oder in einer rinnenförmigen Halterung angeordnet, um den besagten Zwischenraum zu bilden.

Als eine Ausführungsform ist die besagte erste Abschirmkappe in mehrere rinnenförmigen Halterungen eingesetzt, wobei die Öffnungsrichtung mindestens einer Halterung entgegengesetzt zu den Öffnungsrichtungen der anderen Halterungen ist.

Als eine Ausführungsform weisen die besagte erste Abschirmkappe und zweite Abschirmkappe jeweils eine Öffnung auf, weist der besagte Wandler einen Wicklungsanschluss auf, kann der besagte Wicklungsanschluss aus der besagten Öffnung herausragen. Natürlich ist es am besten, wenn die Öffnung relativ klein angeordnet werden kann, andernfalls kann die Schutzwirkung der finalen Einheit beeinträchtigt werden.

Bevorzugt beträgt das Gewicht von Nickel oder Kobalt 50 % und mehr des Gesamtgewichts der besagten ersten Abschirmkappe, oder beträgt das Gewicht von Eisen 97 % und mehr des Gesamtgewichts der besagten ersten Abschirmkappe. Da das Material der ersten Abschirmkappe eine relativ hohe magnetische Leitfähigkeit und einen relativ niedrigen remanenten Magnetismus aufweist, kann deshalb der magnetische Fluss, der von äußeren magnetischen Störfeldern hervorgerufen wird, effektiver abgeleitet werden.

Diese Erfindung legt außerdem ein Stromwandlermodul vor, das einen Stromwandler umfasst, wobei sich der besagte Stromwandler im ersten Hohlraum des von einem beliebigen der vorstehenden Abschnitte beschriebenen Schutzgehäuses befindet. Durch die Verwendung dieses Stromwandlermoduls können die Einflüsse äußerer Störungen auf die Messergebnisse des Stroms effektiv verringert werden.

### Beschreibung der Zeichnungen

Nachfolgend werden in klarer und leicht verständlicher Form durch die Beschreibung der bevorzugten Ausführungsbeispiele und in Verbindung mit den Zeichnungen die oben genannten Besonderheiten, technischen Merkmale und Vorzüge dieser Erfindung und ihre Realisierungsformen weitergehend beschrieben, wobei:
Zeichnung 1 eine schematische Darstellung eines Ausführungsbeispiels des Stromwandlermoduls mit Schutzgehäuse dieser Erfindung zeigt;
Zeichnung 2 eine schematische Explosionsdarstellung des in Zeichnung 1 gezeigten Ausführungsbeispiels zeigt;
Zeichnung 3 eine schematische Darstellung des Ausführungsbeispiels eines weiteren Stromwandlermoduls mit Schutzgehäuse dieser Erfindung zeigt;
Zeichnung 4 eine schematische Darstellung des magnetischen Flusses des in Zeichnung 1 gezeigten Ausführungsbeispiels zeigt;
Zeichnung 5 eine schematische Darstellung der in Zeichnung 4 gezeigten äquivalenten magnetischen Widerstände zeigt.

Erklärung der Beschriftung:
1 - Stromwandlermodul; 2a - erstes Obergehäuse; 2b - erstes Untergehäuse; 2c - erstes Obergehäuse; 2d - erstes Untergehäuse; 21 - erster Untergehäuseaußenring; 22 - erster Untergehäuseinnenring; 23 - erster Hohlraum; 25 - Öffnung; 3a - zweites Obergehäuse; 3b - zweites Untergehäuse; 3c - zweites Obergehäuse; 3d - zweites Untergehäuse; 31 - zweiter Untergehäuseaußenring; 32 - zweiter Untergehäuseinnenring; 33 - zweiter Hohlraum; 35 - Öffnung; 4 - Stromwandler; 9a - obere Halterung; 9b - untere Halterung; 9 - rinnenförmige Halterung; 10 - rinnenförmige Halterung; 11 - rinnenförmige Halterung; 12 - Wicklungsanschluss; 13 - Öffnung; 14 - Öffnung; 15 - Öffnung; 16 - Öffnung

### Konkrete Ausführungsformen

Für ein klareres Verständnis der technischen Merkmale, Ziele und Wirkungen der Erfindung werden nunmehr mit Verweis auf die Zeichnungen die konkreten Ausführungsformen dieser Erfindung beschrieben, identische Beschriftungen in den einzelnen Zeichnungen bedeuten identische Teile.

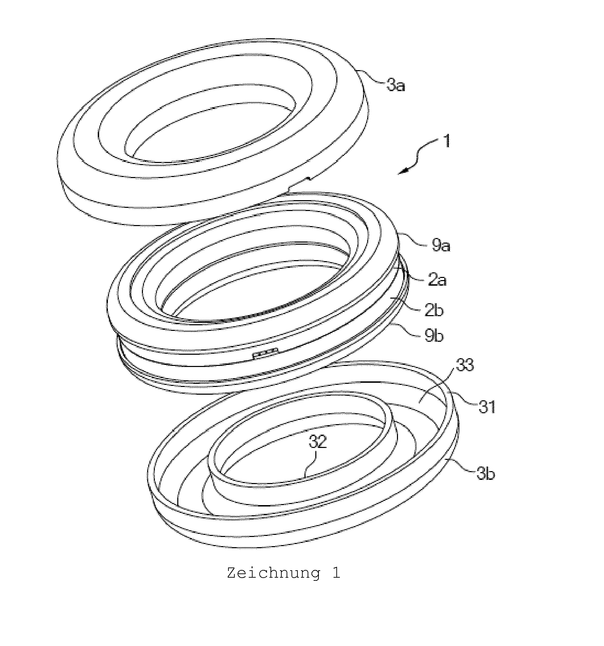

Diese Erfindung legt ein Schutzgehäuse für einen Stromwandler vor, wie in Zeichnung 1 dargestellt, umfasst das besagte Schutzgehäuse mindestens eine erste Abschirmkappe (2a, 2b) und zweite Abschirmkappe (3a, 3b), wobei:
- die besagte erste Abschirmkappe (2a, 2b) einen ersten Hohlraum aufweist, der besagte erste Hohlraum für die Aufnahme des besagten Stromwandlers verwendet werden kann,
- die besagte zweite Abschirmkappe (3a, 3b) einen zweiten Hohlraum 33 aufweist, der besagte zweite Hohlraum 33 für die Aufnahme der besagten ersten Abschirmkappe (2a, 2b) verwendet werden kann.

Obwohl in Zeichnung 1 mit dem Beispiel eines Schutzgehäuses mit einer nur zweischichtigen Abschirmkappe die Beschreibung erfolgt, kann jedoch verstanden werden, dass auf dieser Grundlage weiterhin noch mehr Abschirmkappen nacheinander zur Umhüllung angeordnet werden können, zum Beispiel, wenn außerhalb der zweiten Abschirmkappe eine weitere Abschirmkappe angeordnet wird und die dritte Abschirmkappe einen dritten Hohlraum aufweist, dann kann die zweite Abschirmkappe im dritten Hohlraum platziert werden.

Konkret zum Aufbau des Schutzgehäuses erfolgt nun mit einer konkreten Ausführungsform als Beispiel die Beschreibung.

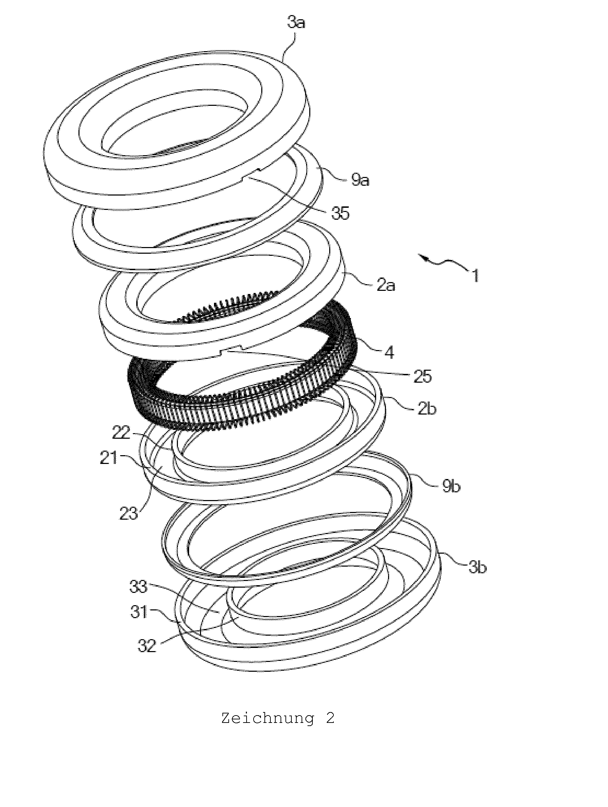

Wie in Zeichnung 2 dargestellt, weist die erste Abschirmkappe einen zweigeteilten Aufbau auf und wird von dem ersten Obergehäuse 2a und dem ersten Untergehäuse 2b durch gegenseitiges Aufsetzen und Verbinden gebildet, die erste Abschirmkappe ist annähernd ringförmig, natürlich kann auch verstanden werden, dass die erste Abschirmkappe außerdem einen quadratisch-ringförmigen oder sonstigen ringförmigen Aufbau aufweisen kann.

Der Innenkreis und Außenkreis des ersten Untergehäuses 2b erstrecken sich jeweils in Axialrichtung und bilden den Innenring 22 und den Außenring 21, der Innenring 22 und der Außenring 21 definieren den ersten Hohlraum 23 des ersten Untergehäuses 2b.

Das erste Obergehäuse 2a kann somit verbindend auf das erste Untergehäuse 2b aufgesetzt werden, auf diese Weise kann dann der Wandler 4 im Inneren dieses ersten Hohlraums 23 angeordnet werden. Um den Wicklungsanschluss des Wandlers 4 herauszuführen, wird gleichzeitig auf dem ersten Obergehäuse 2a noch eine relativ kleine Öffnung 25 angeordnet.

Das Material der ersten Abschirmkappe kann eine relativ hohe magnetische Leitfähigkeit und einen relativ niedrigen remanenten Magnetismus aufweisen, zum Beispiel beträgt das Gewicht von Nickel oder Kobalt 50 % und mehr des Gesamtgewichts der ersten Abschirmkappe, oder das Gewicht von Eisen beträgt 97 % und mehr des Gesamtgewichts der besagten ersten Abschirmkappe, auf diese Weise kann dann der magnetische Fluss von äußeren magnetischen Störfeldern einfach durch die Abschirmkappe abgeleitet werden.

Die zweite Abschirmkappe weist ebenfalls einen zweigeteilten Aufbau auf und wird von dem zweiten Obergehäuse 3a und dem zweiten Untergehäuse 3b durch gegenseitiges Aufsetzen und Verbinden gebildet, wie die erste Abschirmkappe ist die zweite Abschirmkappe annähernd ringförmig, natürlich kann verstanden werden, dass die zweite Abschirmkappe außerdem einen quadratisch-ringförmigen oder sonstigen ringförmigen Aufbau aufweisen kann, ihre Gestalt muss jedoch gewährleisten, dass die den Wandler 4 umhüllende erste Abschirmkappe in der zweiten Abschirmkappe platziert werden kann.

Der Innenkreis und Außenkreis des zweiten Untergehäuses 3b erstrecken sich jeweils in Axialrichtung und bilden den Innenring 32 und den Außenring 31, der Innenring 32 und der Außenring 31 definieren den zweiten Hohlraum 33 des zweiten Untergehäuses 3b.

Das zweite Obergehäuse 3a kann somit verbindend auf das zweite Untergehäuse 3b aufgesetzt werden, auf diese Weise kann dann die erste Abschirmkappe im Inneren dieses zweiten Hohlraums 33 angeordnet werden. Um den Wicklungsanschluss des Wandlers 4 weiterhin nach außen herauszuführen, wird gleichzeitig auf dem zweiten Obergehäuse 3a ebenfalls gleichermaßen eine relativ kleine Öffnung 35 angeordnet.

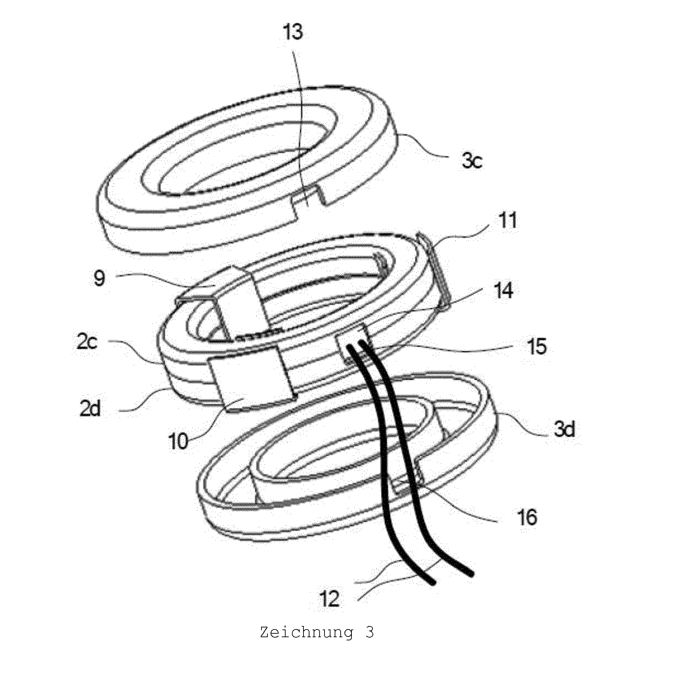

In dem in Zeichnung 2 dargestellten Ausführungsbeispiel ist nur auf dem ersten Obergehäuse 2a und dem zweiten Obergehäuse 3a eine Öffnung vorgesehen, wie Zeichnung 3 zeigt, kann auch auf dem ersten Untergehäuse 2d und dem zweiten Untergehäuse 3d jeweils eine Öffnung 15 und 16 angeordnet werden, die Öffnung 15 und die auf dem ersten Obergehäuse 2c angeordnete Öffnung 14 bilden eine relativ große Öffnung, die Öffnung 16 und die auf dem zweiten Obergehäuse 3c angeordnete Öffnung 13 bilden eine relativ große Öffnung, wodurch die Herausführung des Anschlusses 12 erleichtert wird. Natürlich ist es am besten, wenn die Öffnung nicht übermäßig groß angeordnet werden muss, andernfalls kann vielleicht die Wirkung der Einheit beeinträchtigt werden.

Für die zweite Abschirmkappe kann ebenfalls das gleiche Material wie für die erste Abschirmkappe verwendet werden, natürlich können auch andere verfügbare Materialien für die Bearbeitung der zweiten Abschirmkappe verwendet werden.

Um den magnetischen Fluss durch die zweite Abschirmkappe weiter zu verringern, kann außerdem zwischen der zweiten Abschirmkappe und der ersten Abschirmkappe ein Luftzwischenraum angeordnet sein, um einen magnetischen Widerstand zu bilden.

In dem in Zeichnung 2 gezeigten Ausführungsbeispiel ist zwischen der ersten Abschirmkappe und der zweiten Abschirmkappe eine ringförmige Halterung angeordnet, diese ringförmige Halterung hat zwei Teile, die obere Halterung 9a kann auf das erste Obergehäuse 2a aufgesetzt werden, während die untere Halterung 9b auf das erste Untergehäuse 2b aufgesetzt werden kann, da die Halterung selbst eine bestimmte Dicke aufweist und außerdem die ringförmige Halterung auch im zweiten Hohlraum 33 platziert werden kann, besteht deshalb zwischen der zweiten Abschirmkappe und der ersten Abschirmkappe ein Zwischenraum mit einem magnetischen Widerstand.

Natürlich kann auch eine Halterung mit einem anderen Aufbau verwendet werden, bei dem, wie in Zeichnung 3 dargestellt, der Oberteil 2c und der Unterteil 2d der ersten Abschirmkappe dann in drei rinnenförmigen Halterungen (9, 10, 11) eingesetzt werden, wobei die Öffnungsrichtung mindestens einer Halterung 9 entgegengesetzt zu den Öffnungsrichtungen der anderen Halterungen ist.

Außerdem kann noch zwischen der ersten Abschirmkappe und der zweiten Abschirmkappe ein Füllmaterial eingefüllt werden, zum Beispiel Harz oder Gummi usw., um den besagten Zwischenraum zu bilden.

Diese Erfindung legt außerdem ein Modul vor, das einen Stromwandler 4 umfasst, der Wandler 4 ist dann im ersten Hohlraum 33 innerhalb der ersten Abschirmkappe platziert.

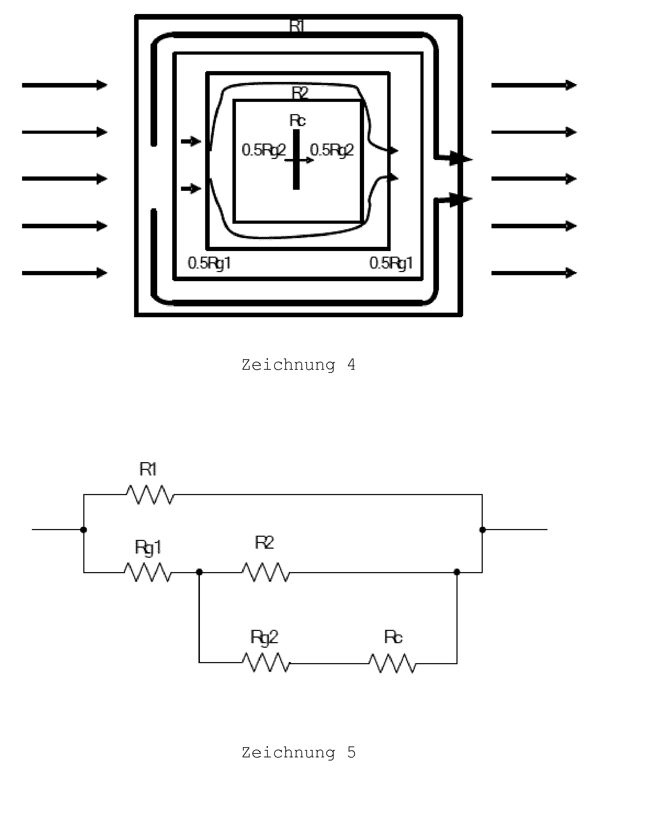

Zeichnung 4 zeigt die Verteilung des magnetischen Flusses einer solchen zweischichtigen Abschirmkappe aus Zeichnung 1, während Zeichnung 5 eine schematische Darstellung der äquivalenten magnetischen Widerstände ist. Es ist ersichtlich, dass aufgrund der Verwendung der ersten Abschirmkappe des Schutzgehäuses, die aus einem Material mit hoher magnetischer Leitfähigkeit und niedrigem remanenten Magnetismus hergestellt wird, und der Existenz eines Luftzwischenraums zwischen der ersten Abschirmkappe und der zweiten Abschirmkappe (der magnetische Widerstand dieses Luftzwischenraums ist Rg1), zwischen dem in der ersten Abschirmkappe platzierten Stromwandler und der ersten Abschirmkappe ebenfalls ein bestimmter Luftzwischenraum besteht (der magnetische Widerstand dieses Luftzwischenraums ist Rg2).

Der magnetische Widerstand R1 der zweiten Abschirmkappe und der magnetische Widerstand R2 der ersten Abschirmkappe werden viel kleiner als die magnetischen Widerstände Rg1 und Rg2 des Luftzwischenraums sein, deshalb wird ein Großteil der äußeren magnetischen Störfelder durch die zweite Abschirmkappe abgeleitet, nur ein kleiner Teil des magnetischen Flusses durchdringt den Luftzwischenraum zwischen der ersten Abschirmkappe und der zweiten Abschirmkappe und erreicht die Oberfläche der ersten Abschirmkappe. Aus den gleichen Gründen wird ein Großteil des magnetischen Flusses, der die Oberfläche der ersten Abschirmkappe erreicht, von der ersten Abschirmkappe abgeleitet, nur ein noch geringerer Teil des magnetischen Flusses durchdringt die erste Abschirmkappe. Dies zeigt, dass durch eine Erhöhung der Schichtenzahl der Abschirmkappe die Störungen äußerer Magnetfelder auf den Wandler effektiv verringert werden kann, und wenn gewährleistet wird, dass bei jeder Abschirmkappe zwischen den Schichten ein Luftzwischenraum existiert, oder ein Material mit hoher magnetischer Leitfähigkeit und niedrigem remanentem Magnetismus für die Herstellung der ersten Abschirmkappe des Schutzgehäuses gewählt wird, dann der Schutzeffekt der Abschirmkappen enorm erhöht werden kann.

In diesem Text steht "schematisch" für "dienen als Ausführungsbeispiel, Beispiel oder Beschreibung", in diesem Text als "schematisch" beschriebene zeichnerische Darstellungen und Ausführungsformen sollen nicht als eine bevorzugtere oder vorteilhaftere technische Lösung interpretiert werden.

Die Reihe von detaillierten Beschreibungen, die von vorstehendem Text aufgeführt werden, sind lediglich auf diese Erfindung gerichtete konkrete Beschreibungen möglicher Ausführungsbeispiele, sie dienen keineswegs dazu, den Schutzumfang dieser Erfindung einzuschränken, alle äquivalenten Ausführungsbeispiele oder Modifikationen, die ohne Verlassen der Verarbeitungsgüte dieser Erfindung gemacht werden, sollen im Schutzumfang dieser Erfindung enthalten sein.

## Patentansprüche

1. Schutzgehäuse für einen Stromwandler (4), **dadurch gekennzeichnet, dass** das besagte Schutzgehäuse mindestens eine erste Abschirmkappe (2a, 2b; 2c, 2d) und zweite Abschirmkappe (3a, 3b; 3c, 3d) umfasst,
- die besagte erste Abschirmkappe (2a, 2b; 2c, 2d) einen ersten Hohlraum (23) aufweist, der besagte erste Hohlraum (23) für die Aufnahme des besagten Stromwandlers (4) verwendet werden kann,
- die besagte zweite Abschirmkappe (3a, 3b; 3c, 3d) einen zweiten Hohlraum (33) aufweist, der besagte zweite Hohlraum (33) für die Aufnahme der besagten ersten Abschirmkappe (2a, 2b; 2c, 2d) verwendet werden kann.

2. Schutzgehäuse gemäß Anspruch 1, **dadurch gekennzeichnet, dass** das besagte Schutzgehäuse noch eine dritte Abschirmkappe umfasst, die besagte dritte Abschirmkappe einen dritten Hohlraum aufweist, der besagte dritte Hohlraum für die Aufnahme der besagten zweiten Abschirmkappe (3a, 3b; 3c, 3d) verwendet wird.

3. Schutzgehäuse gemäß Anspruch 1, **dadurch gekennzeichnet, dass** die besagte erste Abschirmkappe (2a, 2b; 2c, 2d) durch gegenseitiges Aufsetzen und Verbinden des ersten Obergehäuses (2a; 2c) und des ersten Untergehäuses (2b; 2d) gebildet wird, die besagte zweite Abschirmkappe (3a, 3b; 3c, 3d) durch gegenseitiges Aufsetzen und Verbinden des zweiten Obergehäuses (3a; 3c) und des zweiten Untergehäuses (3b; 3d) gebildet wird.

4. Schutzgehäuse gemäß Anspruch 1, **dadurch gekennzeichnet, dass** zwischen der besagten ersten Abschirmkappe (2a, 2b; 2c, 2d) und zweiten Abschirmkappe (3a, 3b; 3c, 3d) ein Zwischenraum vorhanden ist.

5. Schutzgehäuse gemäß Anspruch 4, **dadurch gekennzeichnet, dass** zwischen der besagten ersten Abschirmkappe (2a, 2b; 2c, 2d) und zweiten Abschirmkappe (3a, 3b; 3c, 3d) ein Füllmaterial eingefüllt ist, um den besagten Zwischenraum zu bilden.

6. Schutzgehäuse gemäß Anspruch 4, **dadurch gekennzeichnet, dass** die besagte erste Abschirmkappe (2a, 2b; 2c, 2d) in einer ringförmigen Halterung (9a, 9b) oder in einer rinnenförmigen Halterung (9; 10; 11) angeordnet ist, um den besagten Zwischenraum zu bilden.

7. Schutzgehäuse gemäß Anspruch 6, **dadurch gekennzeichnet, dass** die besagte erste Abschirmkappe (2a, 2b; 2c, 2d) in mehrere rinnenförmigen Halterungen (9; 10; 11) eingesetzt ist, wobei die Öffnungsrichtung mindestens einer Halterung (9) entgegengesetzt zu den Öffnungsrichtungen der anderen Halterungen (10; 11) ist.

8. Schutzgehäuse gemäß Anspruch 1, **dadurch gekennzeichnet, dass** die besagte erste Abschirmkappe (2a, 2b; 2c, 2d) und zweite Abschirmkappe (3a, 3b; 3c, 3d) jeweils eine Öffnung (25, 35; 13, 14, 15, 16) aufweisen, der besagte Wandler (4) einen Wicklungsanschluss (12) aufweist, der besagte Wicklungsanschluss (12) aus der besagten Öffnung (25, 35; 13, 14, 15, 16) herausragen kann.

9. Schutzgehäuse gemäß Anspruch 1, **dadurch gekennzeichnet, dass** das Gewicht von Nickel oder Kobalt 50 % und mehr des Gesamtgewichts der besagten ersten Abschirmkappe (2a, 2b; 2c, 2d) beträgt, oder das Gewicht von Eisen 97 % und mehr des Gesamtgewichts der besagten ersten Abschirmkappe (2a, 2b; 2c, 2d) beträgt.

10. Stromwandlermodul, umfassend einen Stromwandler (4), **dadurch gekennzeichnet, dass** sich der besagte Stromwandler (4) im ersten Hohlraum (23) des Schutzgehäuses gemäß einem beliebigen der Ansprüche 1 bis 9 befindet.
